# EUROPÄISCHE PATENTSCHRIFT

(11) **EP 2 601 237 B1**
(45) Veröffentlichungstag und Bekanntmachung des Hinweises auf die Patenterteilung: **20.01.2016**
(21) Anmeldenummer: 11738957.7
(22) Anmeldetag: 08.07.2011
(51) Int. Cl.: C08G 61/12, H01L 51/00

(54) **POLYMERE MIT STRUKTUREINHEITEN, DIE ELEKTRONEN-TRANSPORT-EIGENSCHAFTEN AUFWEISEN**
POLYMERS HAVING STRUCTURAL UNITS WITH ELECTRON TRANSPORT PROPERTIES
POLYMÈRES DOTÉS D'UNITÉS STRUCTURELLES QUI PRÉSENTENT DES PROPRIÉTÉS DE TRANSPORT ÉLECTRONIQUE

(30) Priorität: 02.08.2010 DE 102010033080
(43) Veröffentlichungstag der Anmeldung: 12.06.2013
(60) Teilanmeldung: 13004268.2
(73) Patentinhaber: Merck Patent GmbH, 64293 Darmstadt (DE)
(72) Erfinder: HEUN, Susanne, 65812 Bad Soden (DE); LUDEMANN, Aurélie, 60322 Frankfurt am Main (DE); ANÉMIAN, Rémi Manouk, Seoul 657-169 (KR)
(86) Internationale Anmeldenummer: PCT/EP2011/003430
(87) Internationale Veröffentlichungsnummer: WO 2012/016627

(56) Entgegenhaltungen:
- WO-A1-02/077060

## Beschreibung

Die vorliegende Erfindung betrifft ein Polymer, das mindestens eine Struktureinheit enthält, die Elektronen-Transport-Eigenschaften aufweist, Verfahren zu deren Herstellung, Mischungen (Blends), Lösungen und Formulierungen, die diese Polymere enthalten. Desweiteren betrifft die vorliegende Erfindung die Verwendung dieser Polymere in elektronischen Vorrichtungen, insbesondere in organischen Elektrolumineszenzvorrichtungen, sogenannten OLEDs (OLED = Organic Light Emitting Diodes), sowie diese organischen Elektrolumineszenzvorrichtungen selbst. Die erfindungsgemäßen Polymere zeigen eine verbesserte Effizienz und eine höhere Lebensdauer, insbesondere bei Verwendung in OLEDs.

Polymere für optoelektronische Anwendungen sind vorzugsweise entweder konjugierte oder teilweise konjugierte Hauptkettenpolymere, bei denen hinsichtlich der optoelektronischen Eigenschaften das Polymergrundgerüst selbst eine wichtige Rolle spielt, Seitenkettenpolymere, deren Funktionalität durch Transporteinheiten und/oder Emitter verwirklicht wird, die an das Grundgerüst chemisch gebunden ist, oder neutrale Polymere, die nur für die filmbildenden Eigenschaften verant-wortlich sind (bekannt von organischen Photorezeptoren, bei denen die Lochtransportmaterialien typischerweise in Polycarbonat gelöst werden).

Polymere werden bereits seit langem intensiv als vielversprechende Materialien in OLEDs untersucht. OLEDs, die als organische Materialien Polymere aufweisen, werden dabei häufig auch als PLEDs (PLED = Polymeric Light Emitting Diodes) bezeichnet. Ihre einfache Herstellung verspricht eine kostengünstige Herstellung von entsprechenden Leuchtvorrichtungen.

Da PLEDs meist nur aus einer lichtemittierenden Schicht bestehen, werden Polymere benötigt, die möglichst sämtliche Funktionen (Ladungsinjektion, Ladungstransport, Rekombination) einer OLED in sich vereinigen können. Um diese Anforderungen zu erfüllen, werden während der Polymerisation unterschiedliche Monomere eingesetzt, die die entsprechenden Funktionen übernehmen. So ist es für die Erzeugung aller drei Emissionsfarben in der Regel nötig, bestimmte Comonomere in die entsprechenden Polymere einzupolymerisieren (vgl. z.B. WO 00/46321 A1, WO 03/020790 A2 und WO 02/077060 A1). So ist beispielsweise ausgehend von einem blau emittierenden Grundpolymer ("backbone") die Erzeugung der beiden anderen Primärfarben Rot und Grün möglich.

Als Polymere für vollfarbige Anzeigeelemente (Full-Colour-Displays) wurden bereits verschiedene Materialklassen, wie zum Beispiel Poly-para-Phenylene (PPP), vorgeschlagen bzw. entwickelt. So kommen zum Beispiel Poly-Fluoren-, Poly-Spirobifluoren-, Poly-Phenanthren-, Poly-Dihydrophenanthren- und Poly-Indenofluoren-Derivate in Betracht. Auch Polymere, die eine Kombination der genannten Strukturelemente enthalten, wurden bereits vorgeschlagen.

Die wichtigsten Kriterien einer OLED sind Effizienz, Farbe und Lebensdauer. Diese Eigenschaften werden nicht nur durch den/die verwendeten Emitter bestimmt, sondern hängen auch maßgeblich davon ab, wie gut der Ladungstransport in der OLED stattfinden kann. Es ist bekannt, dass in einer PLED sowohl der Elektronentransport als auch der Lochtransport in der Schicht des Licht-emittierenden Polymers (LEP-Schicht) stattfindet. Um die Effizienz und Lebensdauer von OLEDS zu verbessern, ist es notwendig, die Injektion bzw. den Transport der Ladungen in die LEP-Schicht zu erleichtern. Um die sogenannte Lochinjektion bzw. den Lochtransport zu verbessern, wurden eine Reihe neuer Monomere vorgeschlagen, die auf Triarylaminderivaten basieren. Dadurch konnte die Effizienz und Lebensdauer solcher Vorrichtungen verbessert werden. Jedoch werden in der Literatur kaum stabile Elektronen-Transport-Einheiten beschrieben.

Deshalb werden vorwiegend Verbesserungen der Elektronen-Transport-Einheiten gegenüber den aus dem Stand der Technik bekannten Materialien benötigt.

Da PLEDs meist nur aus einer Schicht zusammengesetzt sind, müssen die Einheiten, die den Ladungstransport ermöglichen, direkt durch polymerisierbare Monomere in das Polymer eingebaut werden. So wurde Oxadiazol, das als Elektronen-Transport-Einheit bekannt ist, bereits als Hauptkettenkomponente und Seitenkettenkomponente in konjugierte und nicht-konjugierte Polymere eingebaut. Die Effizienz von Vorrichtungen mit solchen Polymeren war einigermaßen zufriedenstellend, jedoch war die Lebensdauer nicht ausreichend für die Anwendung in OLEDs. Ebenso wurden auch Verbindungen mit mehreren Keto-Gruppen verwendet. Allerdings haben entsprechende Polymere den Nachteil, dass aufgrund der Energielücke solcher Moleküle, diese nicht kompatibel sind mit Einheiten, die im blauen Spektralbereich emittieren.

Es war demnach eine Aufgabe der vorliegenden Erfindung, ein Polymer bereitzustellen, das mindestens eine Wiederholungseinheit enthält, die Elektronen-Transport-Eigenschaften aufweist, somit den Elektronen-transport in elektronischen Vorrichtungen, vorzugsweise PLEDs, erleichtert, und dadurch deren Effizienz steigert.

Die erfindungsgemäße Aufgabe wurde erfindungsgemäß gelöst durch die Bereitstellung eines Polymers, das mindestens eine Struktureinheit der folgenden Formeln (II), (IIIa) und/oder (IIIb) enthält: 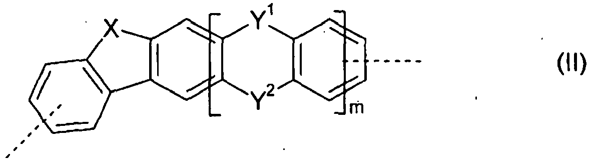 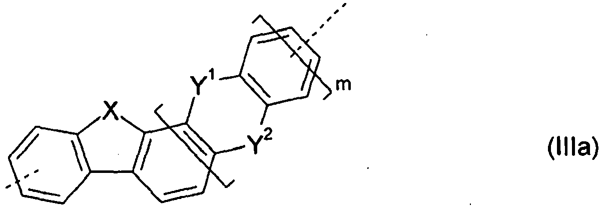 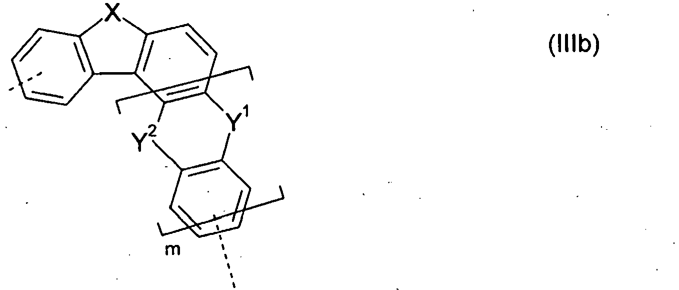 wobei die verwendeten Symbole und Indices die folgende Bedeutung haben:
X ist C(R¹)2,
Y¹ und Y² sind jeweils unabhängig voneinander ausgewählt aus C(R¹)₂, NR¹, C(R¹)₂-C(R¹)₂, CR¹=CR¹ und einer Einfachbindung, jedoch mit der Maßgabe, dass entweder Y¹ oder Y² eine Einfachbindung ist,
m ist 0 oder 1,
R¹ ist jeweils unabhängig voneinander ausgewählt aus H, F, Cl, Br, I, N(Ar¹)₂, C(=O)Ar¹, P(=O)Ar¹₂, S(=O)Ar¹, S(=O)₂Ar¹, CR²=CR²Ar¹, CN, NO₂, Si(R²)₃, B(OR²)₂, OSO₂R², einer geradkettigen Alkyl-, Alkoxy- oder Thioalkoxygruppe mit 1 bis 40 C-Atomen, einer verzweigten oder cyclischen Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch F, Cl, Br, I, CN oder NO₂ ersetzt sein können, eine Aryl-, Aryloxy-, Heteroaryl- oder Heteroaryloxygruppe mit 5 bis 40 C-Atomen, welche auch durch einen oder mehrere nicht-aromatische Reste R¹ substituiert sein kann, wobei auch zwei oder mehrere Reste, vorzugsweise zwei benachbarte Reste, R¹ miteinander ein aliphatisches oder aromatisches, mono- oder polycyclisches Ringsystem bilden können, oder einer Elektronen-Transport-Einheit R³, jedoch mit der Maßgabe, dass mindestens einer der Reste R¹ eine Elektronen-Transport-Einheit R³ ist,
Ar¹ ist bei jedem Auftreten jeweils unabhängig voneinander ausgewählt aus einer Aryl- oder Heteroarylgruppe oder einem aromatischen oder heteroaromatischen Ringsystem,
R² ist jeweils unabhängig voneinander H, ein aliphatischer Kohlenwasserstoffrest mit 1 bis 20 C-Atomen oder ein aromatischer Kohlenwasserstoffrest mit 6 bis 20 C-Atomen, wobei zwei oder mehrere Reste R² auch miteinander ein Ringsystem bilden können,
R³ ist eine Elektronen-Transport-Einheit, die aus der Gruppe ausgewählt wird, die aus Benzimidazol, Triazin, Pyrimidinen, Pyrazinen, Pyridazinen, Phenanthrolinen, Ketonen, Phosphinoxiden und deren Derivaten besteht, und
wobei die gestrichelten Linien an den beiden äußeren Phenylringen, die Bindungen zu den benachbarten Struktureinheiten im Polymer darstellen.

Das aromatische Ringsystem im Sinne der vorliegenden Erfindung enthält vorzugsweise 6 bis 60 C-Atome im Ringsystem. Das heteroaromatische Ringsystem im Sinne der vorliegenden Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind vorzugsweise ausgewählt aus Si, N, P, O, S und/oder Se, besonders bevorzugt-ausgewählt aus N, P, O und/oder S. Unter einem aromatischen oder heteroaromatischen Ringsystem im Sinne der vorliegenden Erfindung soll darüber hinaus ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (vorzugsweise weniger als 10 % der von H verschiedenen Atome), wie z.B. ein C- (sp³-hybridisiert), N- oder O-Atom, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne der vorliegenden Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. P=O oder C=O-Gruppen sind gewöhnlich nicht konjugationsunterbrechend.

Als aromatisches oder heteroaromatisches Ringsystem mit 5 bis 60 Ringatomen, welches noch jeweils mit beliebigen Resten R substituiert und über beliebige Positionen am Aromaten bzw. Heteroaromaten verknüpft sein kann, werden insbesondere Gruppen verstanden, die abgeleitet sind von Phenyl, Naphthyl, Anthracen, Phenanthren, Pyren, Chrysen, Perylen, Fluoranthen, Naphthacen, Tetracen, Pentacen, Benzpyren, Biphenyl, Biphenylen, Binaphthyl, Terphenyl, Terphenylen, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Behzo-carbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin, Benzothiadiazol, Benzanthren, Benzanthracen, Rubicen und Triphenylen.

Besonders bevorzugt als aromatisches oder heteroaromatisches Ringsystem sind Phenyl, Biphenyl, Triphenyl, Naphthyl, Anthracen, Binaphthyl, Phenanthren, Dihydrophenanthren, Pyren, Dihydropyren, Chrysen, Perylen, Tetracen, Benzpyren und Fluoren.

Eine Arylgruppe im Sinne der vorliegenden Erfindung enthält 6 bis 60 C-Atome; eine Heteroarylgruppe im Sinne der vorliegenden Erfindung enthält 2 bis 60 C-Atome und mindestens ein Heteroatom, mit der Maßgabe, dass die Summe aus C-Atomen und Heteroatomen mindestens 5 ergibt. Die Heteroatome sind vorzugsweise ausgewählt aus Si, N, P, O, S und/oder Se; besonders bevorzugt ausgewählt aus N, P, O oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, Benzothiophen, Benzofuran und Indol, verstanden.

Unter dem Begriff "aliphatischer Kohlenwasserstoffrest mit 1 bis 20 Kohlenstoffatomen" wird in der vorliegenden Erfindung ein gesättigter oder ungesättigter, nicht aromatischer Kohlenwasserstoffrest verstanden, der linear, verzweigt oder cyclisch sein kann (Alkylgruppe). Ein oder mehrere Kohlenstoffatome können durch O (Alkoxygruppe), N oder S (Thioalkoxygruppe) ersetzt sein. Zudem können ein oder mehrere Wasserstoffatome durch Fluor ersetzt sein. Beispiele solcher Verbindungen schließen die Folgenden ein: Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Octinyl, Methoxy, Trifluormethoxy, Ethoxy, n-Propoxy, i-Propoxy, n-Butoxy, i-Butoxy, s-Butoxy, t-Butoxy und 2-Methylbutoxy, wobei Methyl, Ethyl, i-Propyl und i-Butyl besonders bevorzugt sind.

In dem Fall, dass zwei Reste R² ein Ringsystem bilden können, stellen diese zwei verknüpften Reste R² vorzugsweise eine bivalente aliphatische Gruppe mit 2 bis 8 Kohlenstoffatomen dar. Beispiele hierfür sind Verbindungen der folgenden Formel -CH₂(CH₂)ₘCH₂-, wobei m = 0, 1, 2, 3, 4, 5 oder 6, vorzugsweise 0, 1, 2 oder 3, ist.

Unter dem Begriff "Elektronen-Transport-Einheit" wird in der vorliegenden Anmeldung eine Einheit verstanden, die in der Lage ist, ein Elektron aus der Umgebung aufzunehmen und wieder an die Umgebung abzugeben.

Die Elektronen-Transport-Einheit R³ ist erfindungsgemäß eine Einheit, die aus der Gruppe ausgewählt wird, die aus Benzimidazolen, Triazinen, Pyrimidinen, Pyrazinen, Pyridazinen, Phenanthrolinen, Ketonen, Phosphinoxiden und deren Derivaten besteht. Die genannten Grundgerüste können dabei durch eine oder mehrere Reste R¹ substituiert oder unsubstituiert vorliegen. Besonders bevorzugt ist R³ ein Benzimidazol, ein Triazin, ein Derivat davon oder ein Keton. Ganz besonders bevorzugt ist R³ ein N-Phenylbenzimidazol oder ein 3,5-Diphenyltriazin.

Überraschenderweise wurde gefunden, dass die erfindungsgemäßen Polymere, die mindestens eine Struktureinheit der Formeln (II), (IIIa) und/oder (IIIb) enthalten, sehr gute Eigenschaften aufweisen. Insbesondere zeigen sie sehr hohe Effizienzen im Vergleich zu bisherigen Referenz-Systemen. Die erfindungsgemäßen Polymere eignen sich insbesondere als Elektronenleiter.

In der vorliegenden Anmeldung sind unter dem Begriff Polymer sowohl polymere Verbindungen, oligomere Verbindungen, sowie Dendrimere zu verstehen. Die erfindungsgemäßen polymeren Verbindungen weisen vorzugsweise 10 bis 10000, besonders bevorzugt 20 bis 5000 und insbesondere 50 bis 2000 Struktureinheiten auf. Die erfindungsgemäßen oligomeren Verbindungen weisen vorzugsweise 2 bis 9 Struktureinheiten auf. Der Verzweigungs-Faktor der Polymere liegt dabei zwischen 0 (lineares Polymer, ohne Verzweigungsstellen) und 1 (vollständig verzweigtes Dendrimer).

Bei den erfindungsgemäßen Polymeren handelt es sich entweder um konjugierte, teilkonjugierte oder nicht-konjugierte Polymere. Bevorzugt sind konjugierte oder teilkonjugierte Polymere.

Die Struktureinheiten der Formeln (II), (IIIa) und (IIIb) können erfindungsgemäß in die Haupt- oder in die Seitenkette des Polymers eingebaut werden, vorzugsweise in die Hauptkette.

"Konjugierte Polymere" im Sinne der vorliegenden Anmeldung sind Polymere, die in der Hauptkette hauptsächlich sp²-hybridisierte (bzw. gegebenenfalls auch sp-hybridisierte) Kohlenstoffatome, die auch durch entsprechende Heteroatome ersetzt sein können, enthalten. Dies bedeutet im einfachsten Fall abwechselndes Vorliegen von Doppel- und Einfachbindungen in der Hauptkette, aber auch Polymere mit Einheiten, wie beispielsweise meta-verknüpftes Phenylen, sollen im Sinne dieser Anmeldung als konjugierte Polymere gelten. "Hauptsächlich" meint, dass natürlich (unwillkürlich) auftretende Defekte, die zu Konjugationsunterbrechungen führen, den Begriff "konjugiertes Polymer" nicht entwerten. Des Weiteren wird in dieser Anmeldung ebenfalls als konjugiert bezeichnet, wenn sich in der Hauptkette beispielsweise Arylamineinheiten, Arylphosphineinheiten, bestimmte Heterocyclen (d.h. Konjugation über N-, O- oder S-Atome) und/oder metallorganische Komplexe (d.h. Konjugation über das Metallatom) befinden. Analoges gilt für konjugierte Dendrimere. Hingegen werden Einheiten wie beispielsweise Alkylbrücken (sp³-hybridisierte Kohlenstoffatome), (Thio)Ether-, Ester-, Amid- oder Imidverknüpfungen eindeutig als nicht-konjugierte Segmente definiert. Unter einem teilkonjugierten Polymer im Sinne der vorliegenden Anmeldung soll ein Polymer verstanden werden, das konjugierte Regionen enthält, die durch nicht konjugierte Abschnitte, gezielte Konjugations-unterbrecher (z.B. Abstandsgruppen) oder Verzweigungen voneinander getrennt sind, z.B. in dem längere konjugierte Abschnitte in der Hauptkette durch nicht-konjugierte Abschnitte unterbrochen sind, bzw. das längere konjugierte Abschnitte in den Seitenketten eines in der Hauptkette nicht-konjugierten Polymers enthält. Konjugierte und teilkonjugierte Polymere können auch konjugierte, teilkonjugierte oder sonstige Dendrimere enthalten.

Unter dem Begriff "Dendrimer" soll in der vorliegenden Anmeldung eine hochverzweigte Verbindung verstanden werden, die aus einem multifunktionellen Zentrum (core) aufgebaut ist, an das in einem regelmäßigen Aufbau verzweigte Monomere gebunden werden, so dass eine baumartige Struktur erhalten wird. Dabei können sowohl das Zentrum als auch die Monomere beliebige verzweigte Strukturen annehmen, die sowohl aus rein organischen Einheiten als auch Organometallverbindungen oder Koordinationsverbindungen bestehen. "Dendrimer" soll hier allgemein so verstanden werden, wie dies z.B. von M. Fischer und F. Vögtle (Angew. Chem., Int. Ed. 1999, 38, 885) beschrieben ist.

In einer weiteren bevorzugten Ausführungsform der vorliegenden Erfindung stehen Einheiten der Formel (I) in Konjugation mit der Polymerhauptkette. Dies kann einerseits dadurch erreicht werden, dass diese Einheiten in die Hauptkette des Polymers so eingebaut werden, dass dadurch die Konjugation des Polymers, wie oben beschrieben, erhalten bleibt. Andererseits können diese Einheiten auch in die Seitenkette des Polymers so verknüpft werden, dass eine Konjugation zur Hauptkette des Polymers besteht. Dies ist z.B. der Fall, wenn die Verknüpfung mit der Hauptkette nur über sp²-hybridisierte (bzw. gegebenenfalls auch über sp-hybridisierte) Kohlenstoffatome, die auch durch entsprechende Heteroatome ersetzt sein können, erfolgt. Erfolgt die Verknüpfung jedoch durch Einheiten, wie z.B. einfache (Thio)Ether-brücken, Ester, Amide oder Alkylenketten, so sind die Einheiten der Formel (I) als nicht-konjugiert zur Hauptkette definiert.

Bevorzugte Struktureinheiten der Formeln (II), (IIIa) und (IIIb) sind die im folgenden abgebildeten Struktureinheiten (Ia) bis (Ih):

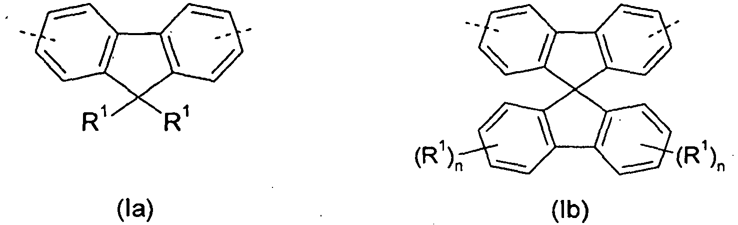

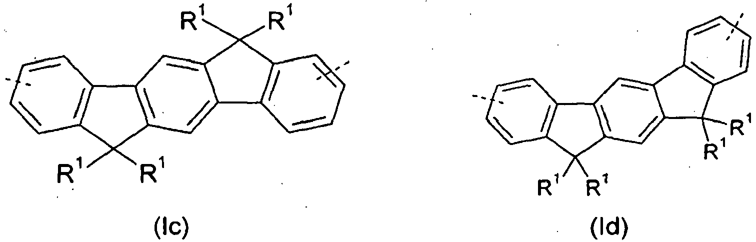

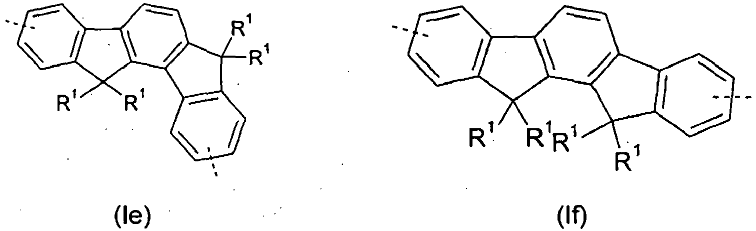

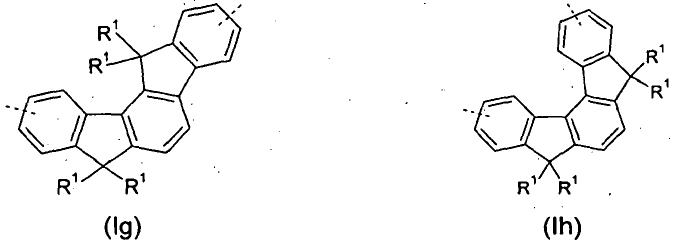

Besonders bevorzugte Struktureinheiten der Formeln (II), (IIIa) und (IIIb) sind die im folgenden abgebildeten Struktureinheiten (Ia1) bis (Ih3):

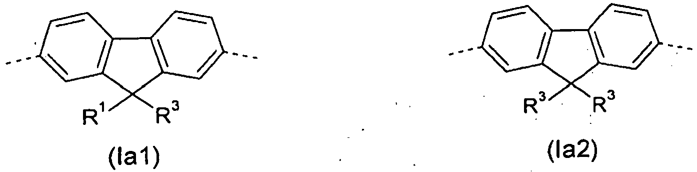

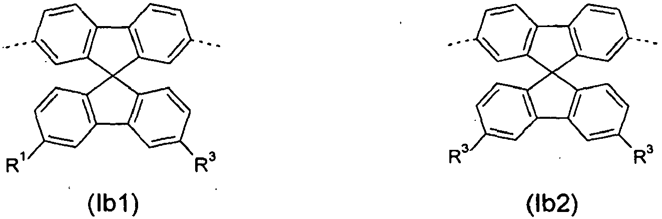

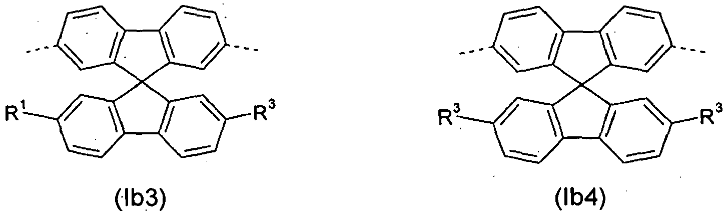

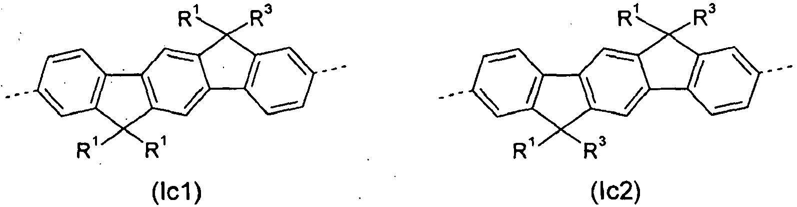

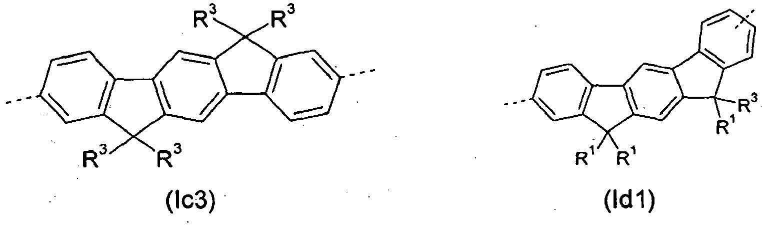

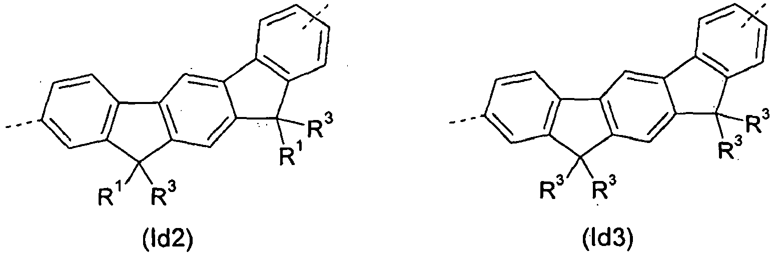

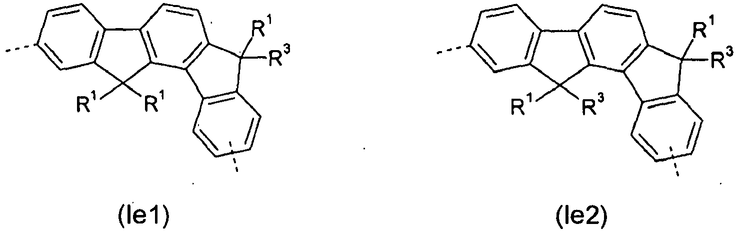

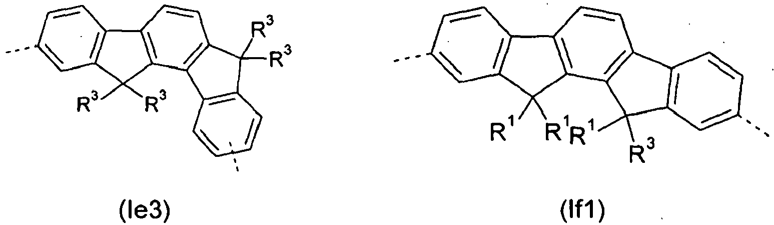

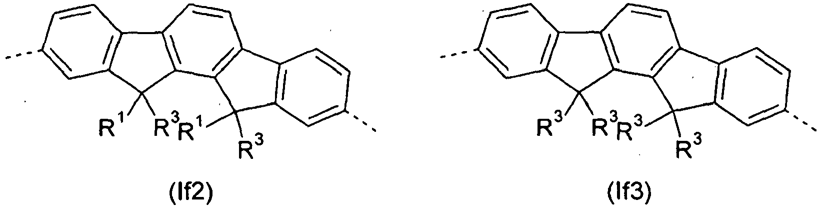

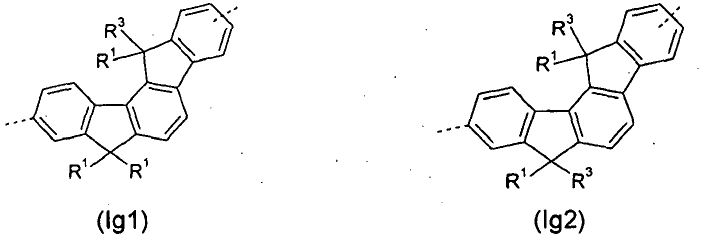

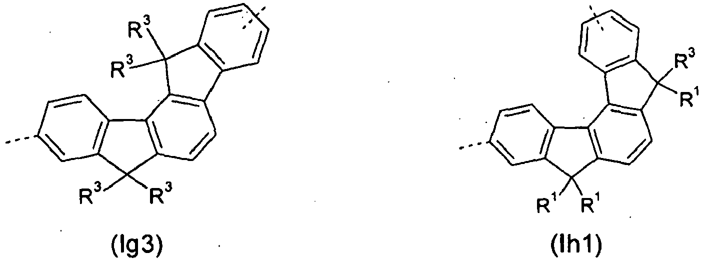

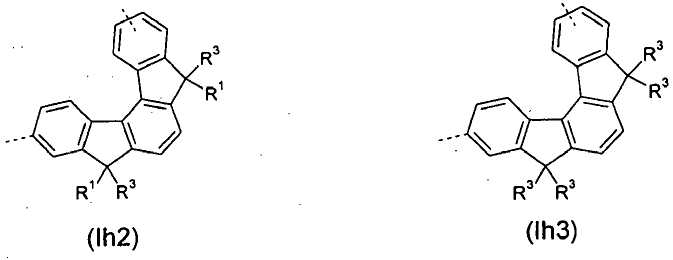

Besonders bevorzugte Struktureinheiten der Formeln (II), (IIIa) und (IIIb) sind die oben als bevorzugt abgebildeten Struktureinheiten der Formeln (Ia) bis (Ih) bzw. die oben als besonders bevorzugt abgebildeten Struktureinheiten der Formeln (Ia1) bis (Ih3) in denen R¹ Wasserstoff bedeutet und R³ ausgewählt ist aus den folgenden Strukureinheiten (IV) bis (VII): 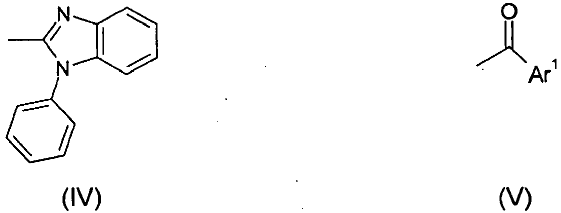 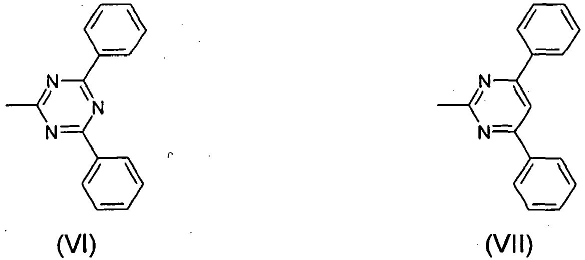 wobei Ar¹ in Formel (V), die in Bezug auf die Formeln (II), (IIIa) und (IIIb) angegebenen Bedeutungen annehmen kann.

In einer weiteren Ausführungsform der vorliegenden Erfindung umfasst das erfindungsgemäße Polymer nicht nur eine Struktureinheit der Formeln (II), (IIIa) oder (IIIb) sondern kann auch Kombinationen von verschiedenen Verbindungen der Formeln (II), (IIIa) und/oder (IIIb) umfassen, d.h. das Polymer kann durch Copolymerisation mehrerer Struktureinheiten der Formel (II), (IIIa) und/oder (IIIb) erhalten werden.

Vorzugsweise enthält das erfindungsgemäße Polymer neben den Struktureinheiten der Formeln (II), (IIIa) und/oder (IIIb) noch weitere Struktureinheiten, die von denen der Formel (I) verschieden sind.

In dem erfindungsgemäßen Polymer beträgt der Anteil der Einheiten der Formeln (II), (IIIa) und/oder (IIIb) 0,01 bis 100 mol%, vorzugsweise 0,1 bis 80 mol%, besonders bevorzugt 1 bis 70 mol% und insbesondere 5 bis 60 mol%, bezogen auf die Gesamtanzahl der Wiederholungseinheiten des Dendrimers, Oligomers oder Polymers.

Die erfindungsgemäßen Polymere können neben einer oder mehrerer Struktureinheiten der Formeln (II), (IIIa) und/oder (IIIb) noch weitere Struktureinheiten enthalten. Dies sind u.a. solche, wie sie in der WO 02/077060 A1 und in der WO 2005/014689 A2 offenbart und umfangreich aufgelistet sind. Diese werden via Zitat als Bestandteil der vorliegenden Erfindung betrachtet. Die weiteren Struktureinheiten können beispielsweise aus den folgenden Klassen stammen:
- Gruppe 1:: Einheiten, welche die Lochinjektions- und/oder Lochtransporteigenschaften der Polymere beeinflussen;
- Gruppe 2:: Einheiten, welche die Elektroneninjektions- und/oder Elektronentransporteigenschaften der Polymere beeinflussen;
- Gruppe 3:: Einheiten, die Kombinationen von Einzeleinheiten der Gruppe 1 und Gruppe 2 aufweisen;
- Gruppe 4:: Einheiten, welche die Emissionscharakteristik insoweit verändern, dass Elektrophosphoreszenz statt Elektrofluoreszenz erhalten werden kann;
- Gruppe 5:: Einheiten, welche den Übergang vom so genannten Singulett- zum Triplettzustand verbessern;
- Gruppe 6:: Einheiten, welche die Emissionsfarbe der resultierenden Polymere beeinflussen;
- Gruppe 7:: Einheiten, welche typischerweise als Backbone verwendet werden;
- Gruppe 8:: Einheiten, welche die Filmmorphologie und/oder die Rheologie der resultierenden Polymere beeinflussen.

Bevorzugte erfindungsgemäße Polymere sind solche, bei denen mindestens eine Struktureinheit Lochtransporteigenschaften aufweist, d.h. die Einheiten aus der Gruppe 1 enthalten.

Struktureinheiten der Gruppe 1, die Lochinjektions- und/oder Lochtransporteigenschaften aufweisen, sind beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-paradioxin-, Phenoxathiin-, Carbazol-, Azulen-, Thiophen-, Pyrrol- und Furaneinheiten sowie deren Derivate und weitere O-, S- oder N-haltige Heterocyclen mit hoch liegendem HOMO (HOMO = höchstes besetztes Molekülorbital). Vorzugsweise führen diese Arylamine und Heterocyclen zu einem HOMO im Polymer von mehr als -5,8 eV (gegen Vakuumlevel), besonders bevorzugt von mehr als -5,5 eV.

Struktureinheiten der Gruppe 2, die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazineinheiten sowie deren Derivate, aber auch Triarylborane und weitere O-, S- oder N-haltige Heterocyclen mit niedrig liegendem LUMO (LUMO = niedrigstes unbesetztes Molekülorbital). Vorzugsweise führen diese Einheiten im Polymer zu einem LUMO von weniger als -1,5 eV (gegen Vakuumlevel), besonders bevorzugt von weniger als -2,0 eV.

Es kann bevorzugt sein, dass in den erfindungsgemäßen Polymeren Einheiten aus der Gruppe 3 enthalten sind, in denen Strukturen, welche die Lochmobilität und welche die Elektronenmobilität erhöhen (also Einheiten aus Gruppe 1 und 2), direkt aneinander gebunden sind oder Strukturen enthalten sind, die sowohl die Lochmobilität als auch die Elektronenmobilität erhöhen. Einige dieser Einheiten können als Emitter dienen und verschieben die Emissionsfarbe ins Grüne, Gelbe oder Rote. Ihre Verwendung eignet sich also beispielsweise für die Erzeugung anderer Emissionsfarben aus ursprünglich blau emittierenden Polymeren.

Struktureinheiten der Gruppe 4 sind solche, welche auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Bevorzugt sind Verbindungen, welche d- oder f-Übergangsmetalle enthalten, die die o.g. Bedingung erfüllen. Besonders bevorzugt sind hier entsprechende Struktureinheiten, welche Elemente der Gruppe 8 bis 10 (Ru, Os, Rh, Ir, Pd, Pt) enthalten. Als Struktureinheiten für die erfindungsgemäßen Polymeren kommen hier z.B. verschiedene Komplexe in Frage, wie sie z.B. in der WO 02/068435 A1, der WO 02/081488 A1, der EP 1239526 A2 und der WO 2004/026886 A2 beschrieben werden. Entsprechende Monomere werden in der WO 02/068435 A1 und in der WO 2005/042548 A1 beschrieben.

Struktureinheiten der Gruppe 5 sind solche, welche den Übergang vom Singulett- zum Triplettzustand verbessern und welche, unterstützend zu den Struktureinheiten der Gruppe 3 eingesetzt, die Phosphoreszenzeigenschaften dieser Strukturelemente verbessern. Hierfür kommen insbesondere Carbazol- und überbrückte Carbazoldimereinheiten in Frage, wie sie z.B. in der WO 2004/070772 A2 und der WO 2004/113468 A1 beschrieben werden. Weiterhin kommen hierfür Ketone, Phosphinoxide, Sulfoxide, Sulfone, Silane und deren Derivate und ähnliche Verbindungen in Frage, wie sie z.B. in der WO 2005/040302 A1 beschrieben werden.

Struktureinheiten der Gruppe 6 sind neben den oben genannten solche, die mindestens noch eine weitere aromatische oder eine andere konjugierte Struktur aufweisen, welche nicht unter die o.g. Gruppen fallen, d.h. die die Ladungsträgermobilitäten nur wenig beeinflussen, die keine metallorganischen Komplexe sind oder die keinen Einfluss auf den Singulett-Triplett-Übergang haben. Derartige Strukturelemente können die Emissionsfarbe der resultierenden Polymere beeinflussen. Je nach Einheit können sie daher auch als Emitter eingesetzt werden. Bevorzugt sind dabei aromatische Strukturen mit 6 bis 40 C-Atomen oder auch Tolan-, Stilben- oder Bisstyrylaryleneinheiten sowie deren Derivate, die jeweils mit einem oder mehreren Resten R substituiert sein können. Besonders bevorzugt ist dabei der Einbau von 1,4 Phenylen-, 1,4-Naphthylen-, 1,4-oder 9,10-Anthrylen-, 1,6-, 2,7- oder 4,9-Pyrenylen-, 3,9- oder 3,10-Perylenylen-, 4,4'-Biphenylylen-, 4,4" Terphenylylen, 4,4'-Bi-1,1'-naphthylylen-, 4,4'-Tolanylen-, 4,4'-Stilbenylen-, 4,4" Bisstyrylarylen-, Benzothiadiazoleinheiten sowie deren Derivate und entsprechenden Sauerstoffderivaten, Chinoxalin-, Phenothiazin-, Phenoxazin-, Dihydrophenazin-, Bis(thiophenyl)arylen-, Oligo(thiophenylen)-, Phenazin-, Rubren-, Pentacen- oder Peryleneinheiten sowie deren Derivate, die vorzugsweise substituiert sind, oder vorzugsweise konjugierte Push-Pull-Systeme (Systeme, die mit Donor- und Akzeptorsubstituenten substituiert sind) oder Systeme wie Squarine oder Chinacridone, die vorzugsweise substituiert sind.

Struktureinheiten der Gruppe 7 sind Einheiten, die aromatische Strukturen mit 6 bis 40 C-Atomen beinhalten, welche typischerweise als Polymer-grundgerüst (Backbone) verwendet werden. Dies sind beispielsweise 4,5-Dihydropyren-, 4,5,9,10-Tetrahydropyren-, Fluoren-, 9,9' Spirobifluoren-, Phenanthren-, 9,10-Dihydrophenanthren-, 5,7-Dihydrodibenzooxepin- und cis- und trans-Indenofluoreneinheiten sowie deren Derivate.

Struktureinheiten der Gruppe 8 sind solche, die die Filmmorphologie und/oder die Rheologie der Polymere beeinflussen, wie z.B. Siloxane, lange Alkylketten oder fluorierte Gruppen, aber auch besonders steife oder flexible Einheiten, wie z.B. flüssigkristallbildende Einheiten oder vernetzbare Gruppen.

Bevorzugt sind erfindungsgemäße Polymere, die gleichzeitig neben einer oder mehrerer der Struktureinheiten der Formeln (II), (IIIa) und/oder (IIIb) zusätzlich noch ein oder mehrere Einheiten ausgewählt aus den Gruppen 1 bis 8 enthalten, die von den erfindungsgemäßen Struktureinheiten verschieden sind. Es kann ebenfalls bevorzugt sein, dass gleichzeitig mehr als eine Struktureinheit aus einer Gruppe vorliegt.

Bevorzugt sind dabei erfindungsgemäß Polymere, die neben einer oder mehrerer der Struktureinheiten der Formeln (II), (IIIa) und/oder (IIIb) noch Einheiten aus der Gruppe 7 enthalten, besonders bevorzugt mindestens 50 mol% dieser Einheiten, bezogen auf die Gesamtzahl der Struktureinheiten im Polymer.

Ebenfalls bevorzugt ist es, dass die erfindungsgemäßen Polymere Einheiten enthalten, die den Ladungstransport und/oder die Ladungsinjektion verbessern, also Einheiten aus der Gruppe 1 und/oder 2; besonders bevorzugt ist ein Anteil von 0,5 bis 30 mol% dieser Einheiten; ganz besonders bevorzugt ist ein Anteil von 1 bis 10 mol% dieser Einheiten.

Besonders bevorzugt ist es weiterhin, dass die erfindungsgemäßen Polymere Struktureinheiten aus der Gruppe 7 und Einheiten aus der Gruppe 1 und/oder 2 enthalten, insbesondere mindestens 50 mol% Einheiten aus der Gruppe 7 und 0,5 bis 30 mol% Einheiten aus der Gruppe 1.

Die erfindungsgemäßen Polymere sind entweder Homopolymere aus Struktureinheiten der Formel (II), (IIIa) oder (IIIb) oder Copolymere. Die erfindungsgemäßen Polymere können linear, verzweigt oder vernetzt sein. Erfindungsgemäße Copolymere können dabei neben einer oder mehreren Struktureinheiten der Formeln (II), (IIIa) und/oder (IIIb), potentiell eine oder mehrere weitere Struktureinheiten aus den oben aufgeführten Gruppen 1 bis 8 besitzen.

Die erfindungsgemäßen Copolymere können statistische, alternierende oder blockartige Strukturen aufweisen oder auch mehrere dieser Strukturen abwechselnd besitzen. Wie Copolymere mit blockartigen Strukturen erhalten werden können und welche weiteren Strukturelemente dafür besonders bevorzugt sind, ist beispielsweise ausführlich in der WO 2005/014688 A2 beschrieben. Diese ist via Zitat Bestandteil der vorliegenden Anmeldung. Ebenso sei an dieser Stelle nochmals hervorgehoben, dass das Polymer auch dendritische Strukturen haben kann.

Die erfindungsgemäßen Polymere weisen vorteilhafte Eigenschaften, insbesondere hohe Lebensdauern, hohe Effizienzen und gute Farbkoordinaten auf.

Die erfindungsgemäßen Polymere werden in der Regel durch Polymerisation von einem oder mehreren Monomeren hergestellt, von denen mindestens ein Monomer im Polymer zu Struktureinheiten der Formel (II), (IIIa) oder (IIIb) führt. Geeignete Polymerisationsreaktionen sind dem Fachmann bekannt und in der Literatur beschrieben. Besonders geeignete und bevorzugte Polymerisationsreaktionen, die zu C-C- bzw. C-N-Verknüpfungen führen, sind folgende:
(A) SUZUKI-Polymerisation;
(B) YAMAMOTO-Polymerisation;
(C) STILLE-Polymerisation;
(D) HECK-Polymerisation;
(E) NEGISHI-Polymerisation;
(F) SONOGASHIRA-Polymerisation;
(G) HIYAMA-Polymerisation; und
(H) HARTWIG-BUCHWALD-Polymerisation.

Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in der WO 03/048225 A2, der WO 2004/037887 A2 und der WO 2004/037887 A2 im Detail beschrieben.

Die C-C-Verknüpfungen sind vorzugsweise ausgewählt aus den Gruppen der SUZUKI-Kupplung, der YAMAMOTO-Kupplung und der STILLE-Kupplung; die C-N-Verknüpfung ist vorzugsweise eine Kupplung gemäß HARTWIG-BUCHWALD.

Gegenstand der vorliegenden Erfindung ist somit auch ein Verfahren zur Herstellung der erfindungsgemäßen Polymere, das dadurch gekennzeichnet ist, dass sie durch Polymerisation gemäß SUZUKI, Polymerisation gemäß YAMAMOTO, Polymerisation gemäß STILLE oder Polymerisation gemäß HARTWIG-BUCHWALD hergestellt werden.

Die erfindungsgemäßen Dendrimere können gemäß dem Fachmann bekannten Verfahren oder in Analogie dazu hergestellt werden. Geeignete Verfahren sind in der Literatur beschrieben, wie z.B. in Frechet, Jean M. J:; Hawker, Craig J., "Hyperbranched polyphenylene and hyperbranched polyesters: new soluble, three-dimensional, reactive polymers", Reactive & Functional Polymers (1995), 26(1-3), 127-36; Janssen, H. M.; Meijer, E. W., "The synthesis and characterization of dendritic molecules", Materials Science and Technology (1999), 20 (Synthesis of Polymers), 403-458; Tomalia, Donald A., "Dendrimer molecules", Scientific American (1995), 272(5), 62-6, WO 02/067343 A1 und WO 2005/026144 A1.

Die Synthese der oben beschriebenen Einheiten aus der Gruppe 1 bis 8 sowie der weiteren emittierenden Einheiten ist dem Fachmann bekannt und in der Literatur, z.B. in der WO 2005/014689 A2, der WO 2005/030827 A1 und WO 2005/030828 A1, beschrieben. Diese Dokumente und die darin zitierte Literatur sind via Zitat Bestandteil der vorliegenden Anmeldung.

Zur Synthese der erfindungsgemäßen Polymere werden die entsprechenden Monomere benötigt. Monomere, die in den erfindungsgemäßen Polymeren zu Struktureinheiten der Formel (II), (IIIa) oder (IIIb) führen sind Verbindungen, die entsprechend substituiert sind und an zwei Positionen geeignete Funktionalitäten aufweisen, die es erlauben, diese Monomereinheit in das Polymer einzubauen.

Es kann außerdem bevorzugt sein, die erfindungsgemäßen Polymere nicht als Reinsubstanz, sondern Mischung (auch als Blend bezeichnet) zusammen mit weiteren beliebigen polymeren, oligomeren, dendritischen oder niedermolekularen Substanzen zu verwenden. Diese können z.B. die elektronischen Eigenschaften verbessern oder selber emittieren.

Ein weiterer Gegenstand der vorliegenden Erfindung ist somit eine Polymermischung, die ein oder mehrere erfindungsgemäße Polymere, sowie eine oder mehrere weitere polymere, oligomere, dendritische oder niedermolekulare Substanzen enthält.

In einer weiteren Ausführungsform der vorliegenden Erfindung ist es bevorzugt, dass eine Mischung ein erfindungsgemäßes Polymer und eine niedermolekulare Substanz enthält. Vorzugsweise ist die niedermolekulare Substanz ein Triplett-Emitter.

In einer weiteren Ausführungsform ist es bevorzugt, dass das Polymer, das Struktureinheiten der Formeln (II), (IIIa) und/oder (IIIb) enthält, zusammen mit einer emittierenden Verbindung in einer emittierenden Schicht eingesetzt wird. In diesem Fall wird das Polymer vorzugsweise in Kombination mit einem oder mehreren phosphoreszierenden Materialien (Triplett-Emitter) eingesetzt. Unter Phosphoreszenz im Sinne der vorliegenden Anmeldung wird die Lumineszenz aus einem angeregten Zustand mit höherer Spinmultiplizität verstanden, also einem Spinzustand > 1, insbesondere aus einem angeregten Triplettzustand oder aus einem MLCT-Mischzustand. Die Mischung aus dem erfindungsgemäßen Polymer bzw. der oben aufgeführten bevorzugten Ausführungsform und der emittierenden Verbindung enthält dann zwischen 99 und 1 Gew.-%, vorzugsweise zwischen 98 und 60 Gew.-%, besonders bevorzugt zwischen 97 und 70 Gew.-%, insbesondere zwischen 95 und 75 Gew.-% des erfindungsgemäßen Polymers bzw. der oben aufgeführten bevorzugten Ausführungsform bezogen auf die Gesamtmischung aus Emitter und Matrixmaterial. Entsprechend enthält die Mischung bis 99 Gew.-%, vorzugsweise bis 40 Gew.-%, besonders bevorzugt bis 30 Gew.-% und insbesondere bis 25 Gew.-% des Emitters bezogen auf die Gesamtmischung aus Emitter und Matrixmaterial.

Darüber hinaus enthält die Mischung im Fall von grünen Triplett-Emittern mindestens 1 Gew.-%, vorzugsweise mindestens 2 Gew.-%, besonders bevorzugt mindestens 3 Gew.-% und insbesondere mindestens 5 Gew.-% des Emitters bezogen auf die Gesamtmischung aus Emitter und Matrixmaterial.

In der oben genannten Ausführungsform, bei der das Polymer, das Struktureinheiten der Formeln (II), (IIIa) und/oder (IIIb) enthält, zusammen mit einer emittierenden Verbindung in einer emittierenden Schicht eingesetzt wird, kann der Anteil der emittierenden Verbindung aber auch deutlich niedriger sein.

Insbesondere im Fall von roten Triplett-Emittern enthält die Mischung vorzugsweise mindestens 0,01 Gew.-% des Emitters bezogen auf die Gesamtmischung, jedoch vorzugsweise weniger als 6 Gew.-% des Emitters bezogen auf die Gesamtmischung.

Als phosphoreszierende Verbindungen eignen sich insbesondere Verbindungen, die bei geeigneter Anregung Licht, vorzugsweise im sichtbaren Bereich, emittieren und außerdem mindestens ein Atom der Ordnungszahl größer 36 und kleiner 84, besonders bevorzugt größer 56 und kleiner 80 enthalten.

Beispiele der oben beschriebenen Emitter können den Anmeldungen WO 00/70655, WO 01/41512, WO 02/02714, WO 02/15645, EP 1191613, EP 1191612, EP 1191614, WO 05/033244 und DE 102008015526 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden.

Die Emitterverbindung in der erfindungsgemäßen Zusammensetzung ist im Sinne der vorliegenden Anmeldung vorzugsweise ein grün emittierender Triplett-Emitter. Ebenso kann es sich bei dem Triplett-Emitter um einen blauen oder roten Triplett-Emitter handeln.

In einer weiteren erfindungsgemäßen Ausführungsform umfasst der Triplett-Emitter vorzugsweise eine metallorganische Verbindungseinheit. Die metallorganische Verbindungseinheit ist vorzugsweise eine metallorganische Koordinationsverbindung. Unter einer metallorganischen Koordinationsverbindung versteht man in der vorliegenden Anmeldung eine Verbindung mit einem Metallatom oder -ion im Zentrum der Verbindung umgeben von einer organischen Verbindung als Ligand. Eine metallorganische Koordinationsverbindung ist zudem dadurch gekennzeichnet, dass mindestens ein Kohlenstoffatom des Ligands über eine Koordinationsbindung an das Zentralmetall bindet. Weiterhin bevorzugt handelt es sich um elektrisch neutrale Triplett-Emitter.

Bevorzugt enthalten die Triplett-Emitter nur chelatisierende Liganden, d.h. Liganden, die über mindestens zwei Bindungsstellen an das Metall koordinieren; besonders bevorzugt ist die Verwendung von zwei oder drei zweizähnigen Liganden, die gleich oder verschieden sein können. Die Bevorzugung chelatisierender Liganden lässt sich durch die höhere Stabilität von Chelatkomplexen begründen.

Dabei weist der Triplett-Emitter vorzugsweise eine Struktur der Formel (IX) auf: 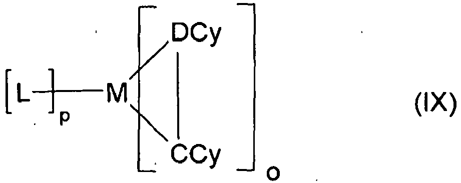 wobei für die verwendeten Symbole und Indices gilt:
- M: ist bei jedem Auftreten gleich oder verschieden ein Hauptgruppenmetall, Übergangsmetall oder Lanthanoid mit der Ordnungszahl > 36;
- DCy: ist bei jedem Auftreten gleich oder verschieden eine cyclische Gruppe, die mindestens ein Donoratom, also ein Atom mit einem freien Elektrodenpaar, vorzugsweise Stickstoff oder Phosphor, enthält, über welches die cyclische Gruppe an das Metall gebunden ist, und die einen oder mehrere Substituenten R⁵ tragen kann; die Gruppen DCy und CCy sind über eine kovalente Bindung miteinander verbunden und können über die Reste R⁵ bzw. R⁶ noch weitere Verknüpfungen miteinander aufweisen;
- CCy: ist bei jedem Auftreten gleich oder verschieden eine cyclische Gruppe, die ein Kohlenstoffatom enthält, über welches die cyclische Gruppe an das Metall gebunden ist, und die einen oder mehrere Substituenten R⁵ tragen kann;
- L: ist bei jedem Auftreten gleich oder verschieden ein zweizähnig chelatisierender Ligand, bevorzugt ein monoanionischer, zweizähnig chelatisierender Ligand;
- R⁵: ist bei jedem Auftreten gleich oder verschieden H, F, Cl, Br, I, NO₂, CN, eine geradkettige, verzweigte oder cyclische Alkyl- oder Alkoxygruppe mit 1 bis 40 C-Atomen, wobei eine oder mehrere nicht benachbarte CH₂-Gruppen durch C=O, C=S, C=Se, C=NR⁶, -R⁶C=CR⁶-, -C≡C-, -O-, -S-, -NR⁶-, Si(R⁶)₂ oder -CONR⁶- ersetzt sein können und wobei ein oder mehrere H-Atome durch F, Cl, Br, I, CN, NO₂ ersetzt sein können, oder ein aromatisches oder heteroaromatisches Ringsystem mit 5 bis 40 aromatischen Ringatomen, das durch einen oder mehrere nicht-aromatische Reste R⁵ substituiert sein kann; dabei können mehrere Substituenten R⁵, sowohl am selben Ring als auch an den beiden unterschiedlichen Ringen zusammen wiederum ein weiteres mono- oder poly-cyclisches, aliphatisches oder aromatisches Ringsystem aufspannen;
- R⁶: ist gleich oder verschieden bei jedem Auftreten H, ein aliphatischer Kohlenwasserstoffrest mit 1 bis 20 C-Atomen oder aromatischer Kohlenwasserstoffrest mit 6 bis 20 C-Atomen;
- o: ist bei jedem Auftreten 1, 2 oder 3, vorzugsweise 2 oder 3, besonders bevorzugt 3;
- p: ist bei jedem Auftreten 0, 1 oder 2, vorzugsweise 0 oder 1, besonders bevorzugt 0.

Bevorzugt sind ebenfalls mehrkernige Triplett-Emitter und Metall-Cluster, deren gemeinsames Merkmal mehr als ein metallisches Zentrum ist.

Die Einheiten der Formel (IX) können symmetrisch oder unsymmetrisch aufgebaut sein.

In einer bevorzugten Ausführungsform der Erfindung sind die Einheiten der Formel (IX) symmetrisch aufgebaut. Diese Bevorzugung ist aus der leichteren synthetischen Zugänglichkeit der Verbindungen zu begründen. So kann es sich bei Einheiten der Formel (IX) vorzugsweise um homoleptische Metallkomplexe handeln, also Metallkomplexe, die nur eine Art Liganden aufweisen.

In einer weiteren bevorzugten Ausführungsform der Erfindung sind die Einheiten der Formel (IX) unsymmetrisch aufgebaut. Dies kann bei den Emissionseigenschaften Vorteile bieten, wenn die Emission nur aus einem der Liganden kommt. So kann es sich bei Einheiten der Formel (IX) vorzugsweise um heteroleptische Komplexe handeln, also Metallkomplexe, die mehr als einen unterschiedlichen Liganden aufweisen.

Bevorzugte Metalle M sind ausgewählt aus der Gruppe der Übergangsmetalle mit einer Ordnungszahl > 36; besonders bevorzugte Metalle M sind ausgewählt aus der Gruppe der Übergangsmetalle mit einer Ordnungszahl > 50. Vorzugsweise ist die Emitterverbindung ein Metallkomplex umfassend ein Metall ausgewählt aus der Gruppe bestehend aus den Übergangsmetallen, den seltenen Erden, den Lanthanoiden und den Actinoiden, vorzugsweise Ir, Ru, Os, Eu, Au, Pt, Cu, Zn, Mo, W, Rh, Pd und Ag, besonders bevorzugt Ir.

Des Weiteren bevorzugt ist, dass der organische Ligand ein Chelatligand ist. Unter einem Chelatligand versteht man einen zwei- oder mehrzähnigen Ligand, der entsprechend über zwei oder mehr Atome an das Zentralmetall binden kann.

In einer weiteren erfindungsgemäßen Ausführungsform ist es bevorzugt, dass eine Mischung ein erfindungsgemäßes Polymer, einen Triplettemitter, der entweder im erfindungsgemäßen Polymer enthalten oder wie in den vorgenannten Ausführungsformen als niedermolekulare Substanz beigemischt ist, und weitere niedermolekulare Substanzen enthält. Diese niedermolekularen Substanzen können über die gleichen Funktionalitäten verfügen wie sie für mögliche Bausteine in den Gruppen 1 bis 8 genannt wurden.

Gegenstand der vorliegenden Erfindung sind weiterhin Lösungen und Formulierungen aus einem oder mehreren erfindungsgemäßen Polymeren oder Blends in einem oder mehreren Lösungsmitteln. Wie solche Lösungen hergestellt werden können, ist dem Fachmann bekannt und beispielsweise in der WO 02/072714 A1, der WO 03/019694 A2 und der darin zitierten Literatur beschrieben.

Geeignete und bevorzugte Lösungsmittel sind beispielsweise Toluol, Anisole, Xylole, Methylbenzoat, Dimethylanisole, Mesitylene, Tetralin, Veratrole und Tetrahydrofuran oder Mischungen davon.

Diese Lösungen können verwendet werden, um dünne Polymerschichten herzustellen, zum Beispiel durch Flächenbeschichtungsverfahren (z.B. Spin-coating) oder durch Druckverfahren (z.B. InkJet Printing).

Polymere, die Struktureinheiten der Formeln (II), (IIIa) und/oder (IIIb) enthalten, welche eine oder mehrere polymerisierbare und damit vernetzbare Gruppen enthalten, eignen sich besonders zur Herstellung von Filmen oder Beschichtungen, insbesondere zur Herstellung von strukturierten Beschichtungen, z.B. durch thermische oder lichtinduzierte in-situ-Polymerisation und in-situ-Vernetzung, wie beispielsweise in-situ-UV-Photopolymerisation oder Photopatterning. Besonders bevorzugt für solche Anwendungen sind erfindungsgemäße Polymere mit einer oder mehreren polymerisierbaren Gruppen, ausgewählt aus Acrylat, Methacrylat, Vinyl, Epoxy und Oxetan. Dabei können sowohl entsprechende Polymere in Reinsubstanz verwendet werden, es können aber auch Formulierungen oder Blends dieser Polymere wie oben beschrieben verwendet werden. Diese können mit oder ohne Zusatz von Lösungsmitteln und/oder Bindemitteln verwendet werden. Geeignete Materialien, Verfahren und Vorrichtungen für die oben beschriebenen Methoden sind z.B. in der WO 2005/083812 A2 beschrieben. Mögliche Bindemittel sind beispielsweise Polystyrol, Polycarbonat, Polyacrylat, Polyvinylbutyral und ähnliche, optoelektronisch neutrale Polymere.

Die erfindungsgemäßen Polymere, Mischungen und Formulierungen können in elektronischen oder elektrooptischen Vorrichtungen bzw. zu deren Herstellung verwendet werden.

Ein weiterer Gegenstand der vorliegenden Erfindung ist somit die Verwendung der erfindungsgemäßen Polymere, Mischungen und Formulierungen in elektronischen oder elektrooptischen Vorrichtungen, vorzugsweise in organischen bzw. polymeren organischen Elektrolumineszenzvorrichtungen (OLED, PLED), organischen Feld-Effekt-Transistoren (OFETs), organischen integrierten Schaltungen (O-ICs), organischen Dünnfilmtransistoren (TFTs), organischen Solarzellen (O-SCs), organischen Laserdioden (O-Laser), organischen photovoltaischen (OPV) Elementen oder Vorrichtungen oder organischen Photorezeptoren (OPCs), besonders bevorzugt in organischen bzw. polymeren organischen Elektrolumineszenzvorrichtungen (OLED, PLED), insbesondere in polymeren organischen Elektrolumineszenzvorrichtungen (PLED).

Wie OLEDs bzw. PLEDs hergestellt werden können, ist dem Fachmann bekannt und wird beispielsweise als allgemeines Verfahren ausführlich in der WO 2004/070772 A2 beschrieben, das entsprechend für den Einzelfall anzupassen ist.

Wie oben beschrieben, eignen sich die erfindungsgemäßen Polymere ganz besonders als Elektrolumineszenzmaterialien in derart hergestellten PLEDs oder Displays.

Als Elektrolumineszenzmaterialien im Sinne der vorliegenden Erfindung gelten Materialien, die in einer oder als aktive Schicht Verwendung finden können. Aktive Schicht bedeutet, dass die Schicht befähigt ist, bei Anlegen eines elektrischen Feldes Licht abzustrahlen (lichtemittierende Schicht) und/oder dass sie die Injektion und/oder den Transport der positiven und/oder negativen Ladungen verbessert (Ladungsinjektions- oder Ladungstransportschicht).

Ein bevorzugter Gegenstand der vorliegenden Erfindung ist daher auch die Verwendung der erfindungsgemäßen Polymere oder Blends in einer PLED, insbesondere als Elektrolumineszenzmaterial.

Gegenstand der vorliegenden Erfindung sind ferner elektronische oder optoelektronische Bauteile, vorzugsweise organische bzw. polymere organische Elektrolumineszenzvorrichtungen (OLED, PLED), organische Feld-Effekt-Transistoren (OFETs), organische integrierte Schaltungen (O-ICs), organische Dünnfilmtransistoren (TFTs), organische Solarzellen (O-SCs), organische Laserdioden (O-Laser), organische photovoltaische (OPV) Elemente oder Vorrichtungen oder organische Photorezeptoren (OPCs), besonders bevorzugt organische bzw. polymere organische Leuchtdioden, insbesondere polymere organische Elektrolumineszenzvorrichtungen, mit einer oder mehreren aktiven Schichten, wobei mindestens eine dieser aktiven Schichten ein oder mehrere erfindungsgemäße Polymere enthält. Die aktive Schicht kann beispielsweise eine lichtemittierende Schicht, eine Ladungstransport-schicht und/oder eine Ladungsinjektionsschicht sein.

Im vorliegenden Anmeldungstext und auch in den im Weiteren folgenden Beispielen wird hauptsächlich auf die Verwendung der erfindungsgemäßen Polymere in Bezug auf PLEDs und entsprechende Displays abgezielt. Trotz dieser Beschränkung der Beschreibung ist es für den Fachmann ohne weiteres erfinderisches Zutun möglich, die erfindungsgemäßen Polymere als Halbleiter auch für die weiteren, oben beschriebenen Verwendungen in anderen elektronischen Vorrichtungen zu benutzen.

Die folgenden Beispiele sollen die Erfindung erläutern, ohne sie einzuschränken. Insbesondere sind die darin beschriebenen Merkmale, Eigenschaften und Vorteile der dem betreffenden Beispiel zu Grunde liegenden definierten Verbindungen auch auf andere, nicht im Detail aufgeführte, aber unter den Schutzbereich der Ansprüche fallende Verbindungen anwendbar, sofern an anderer Stelle nichts Gegenteiliges gesagt wird.

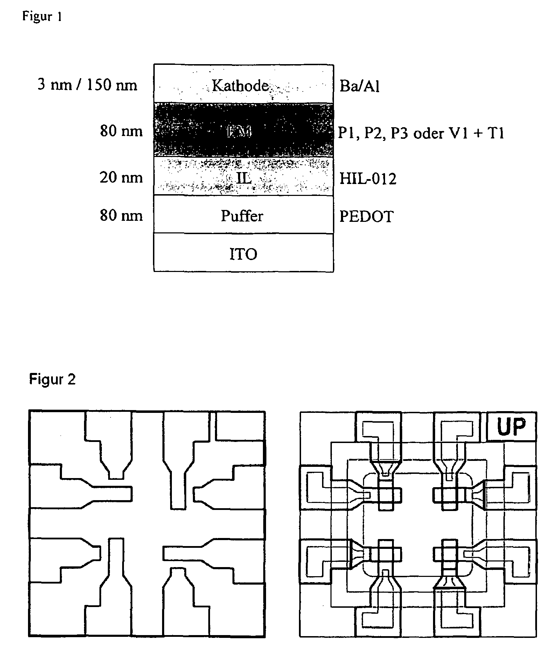

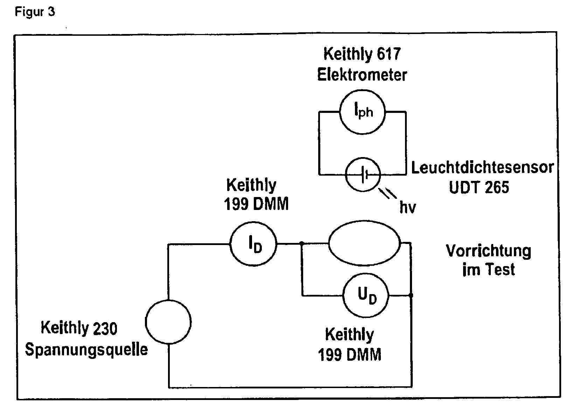

## Patentansprüche

1. Polymer, das mindestens eine Struktureinheit der folgenden Formeln (II), (IIIa) und/oder (IIIb) enthält: 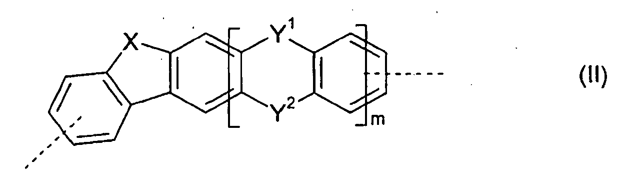 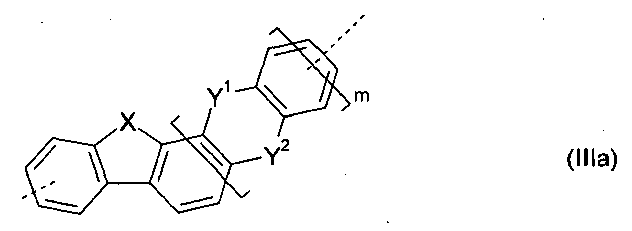 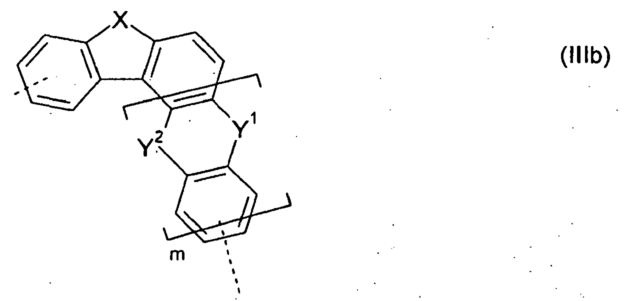 wobei die verwendeten Symbole und Indices die folgende Bedeutung haben:
X ist C(R¹)₂,
Y¹ und Y² sind jeweils unabhängig voneinander ausgewählt aus C(R¹)₂, NR¹, C(R¹)₂-C(R¹)₂, CR¹=CR¹ und einer Einfachbindung, jedoch mit der Maßgabe, dass entweder Y¹ oder Y² eine Einfachbindung ist,
m ist 0 oder 1,
R¹ ist jeweils unabhängig voneinander ausgewählt aus H, F, Cl, Br, I, N(Ar¹)₂, C(=O)Ar¹, P(=O)Ar¹₂, S(=O)Ar¹, S(=O)₂Ar¹, CR²=CR²Ar¹, CN, NO₂, Si(R²)₃, B(OR²)₂, OSO₂R², einer geradkettigen Alkyl-, Alkoxy- oder Thioalkoxygruppe mit 1 bis 40 C-Atomen, einer verzweigten oder cyclischen Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch F, Cl, Br, I, CN oder NO₂ ersetzt sein können, eine Aryl-, Aryloxy-, Heteroaryl- oder Heteroaryloxy-gruppe mit 5 bis 40 C-Atomen, welche auch durch einen oder mehrere nicht-aromatische Reste R¹ substituiert sein kann, wobei auch zwei oder mehrere Reste, vorzugsweise zwei benachbarte Reste, R¹ miteinander ein aliphatisches oder aromatisches, mono- oder polycyclisches Ringsystem bilden können oder einer Elektronen-Transport-Einheit R³, jedoch mit der Maßgabe, dass mindestens einer der Reste R¹ eine Elektronen-Transport-Einheit R³ ist,
Ar¹ ist bei jedem Auftreten jeweils unabhängig voneinander ausgewählt aus einer Aryl- oder Heteroarylgruppe oder einem aromatischen oder heteroaromatischen Ringsystem,
R² ist jeweils unabhängig voneinander H, ein aliphatischer Kohlenwasserstoffrest mit 1 bis 20 C-Atomen oder ein aromatischer Kohlenwasserstoffrest mit 6 bis 20 C-Atomen, wobei zwei oder mehrere Reste R² auch miteinander ein Ringsystem bilden können,
R³ ist eine Elektronen-Transport-Einheit, die aus der Gruppe ausgewählt wird, die aus Benzimidazol, Triazin, Pyrimidinen, Pyrazinen, Pyridazinen, Phenanthrolinen, Ketonen, Phosphinoxiden und deren Derivaten besteht,
wobei die gestrichelten Linien, die Bindungen zu den benachbarten Struktureinheiten im Polymer darstellen.

2. Polymer nach Anspruch 1 , **dadurch gekennzeichnet, dass** es neben der Struktureinheiten der Formel (I) noch weitere Struktureinheiten enthält, die von denen der Formel (I) verschieden sind.

3. Polymer nach Anspruch 1 oder 2, **dadurch gekennzeichnet, dass** der Anteil der Einheiten der Formel (I) 0,01 bis 100 mol% bezogen auf die Gesamtanzahl der Wiederholungseinheiten des Polymers beträgt.

4. Verfahren zur Herstellung eines Polymers nach einem oder mehreren der Ansprüche 1 bis 3, **dadurch gekennzeichnet, dass** es durch SUZUKI-, YAMAMOTO-, STILLE- oder HARTWIG-BUCHWALD-Polymerisation hergestellt wird.

5. Mischung aus einem oder mehreren Polymeren nach einem oder mehreren der Ansprüche 1 bis 3 mit einer weiteren polymeren, oligomeren, dendritischen und/oder niedermolekularen Substanz.

6. Lösung oder Formulierung aus einem oder mehreren Polymeren nach einem oder mehreren der Ansprüche 1 bis 3 oder einer Mischung nach Anspruch 5 in einem oder mehreren Lösungsmitteln.

7. Verwendung eines Polymers nach einem der Ansprüche 1 bis 3, einer Mischung nach Anspruch 5 oder einer Lösung nach Anspruch 6 in elektronischen Vorrichtungen, vorzugsweise in organischen Elektrolumineszenzvorrichtungen.

8. Organische elektronische Vorrichtung mit einer oder mehreren aktiven Schichten, **dadurch gekennzeichnet, dass** mindestens eine dieser aktiven Schichten ein oder mehrere Polymere nach einem oder mehreren der Ansprüche 1 bis 3 oder eine Mischung nach Anspruch 5 enthält.

9. Organische elektronische Vorrichtung nach Anspruch 8, **dadurch gekennzeichnet, dass** es sich um organische bzw. polymere organische Elektrolumineszenzvorrichtungen (OLED, PLED), organische integrierte Schaltungen (O-IC), organische Feld-Effekt-Transistoren (OFET), organische Dünnfilmtransistoren (OTFT), organische Solarzellen (O-SC), organische Laserdioden (O-Laser), organische photo-voltaische (OPV) Elemente oder Vorrichtungen oder organische Photorezeptoren (OPCs), vorzugsweise polymere organische Elektrolumineszenzvorrichtungen (PLED), handelt.

## Claims

1. Polymer which contains at least one structural unit of the following formulae (II), (IIIa) and/or (IIIb): 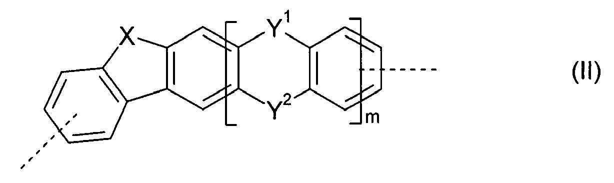 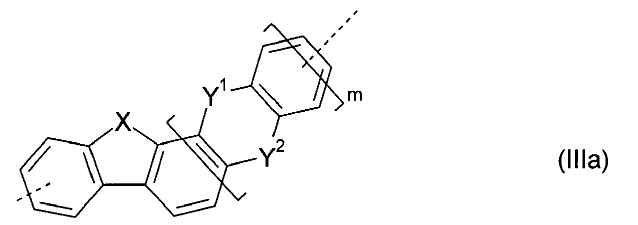 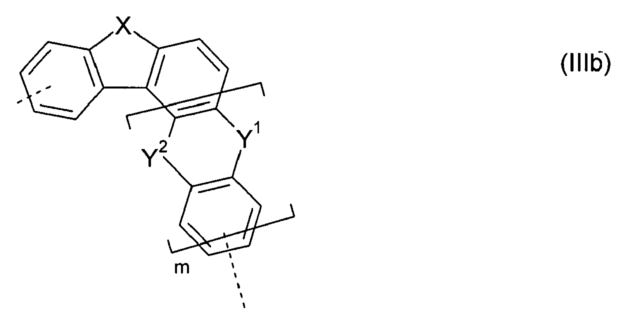 where the symbols and indices used have the following meaning:
X is C(R¹)₂,
Y¹ and Y² are each selected, independently of one another, from C(R¹)₂, NR¹, C(R¹)₂-C(R¹)₂, CR¹=CR¹ and a single bond, but with the proviso that either Y¹ or Y² is a single bond,
m is 0 or 1,
R¹ is in each case selected, independently of one another, from H, F, Cl, Br, I, N(Ar¹)₂, C(=O)Ar¹, P(=O)Ar¹₂, S(=O)Ar¹, S(=O)₂Ar¹, CR²=CR²Ar¹, CN, NO₂, Si(R²)₃, B(OR²)₂, OSO₂R², a straight-chain alkyl, alkoxy or thioalkoxy group having 1 to 40 C atoms, a branched or cyclic alkyl, alkoxy or thioalkoxy group having 3 to 40 C atoms, each of which may be substituted by one or more radicals R², where one or more non-adjacent CH₂ groups may be replaced by R²C=CR², C=C, Si(R²)₂, Ge(R²)₂, Sn(R²)₂, C=O, C=S, C=Se, C=NR², P(=O)(R²), SO, SO₂, NR², O, S or CONR² and where one or more H atoms may be replaced by F, Cl, Br, I, CN or NO₂, an aryl, aryloxy, heteroaryl or heteroaryloxy group having 5 to 40 C atoms, which may also be substituted by one or more non-aromatic radicals R¹, where, in addition, two or more radicals, preferably two adjacent radicals, R¹ may form an aliphatic or aromatic, mono- or polycyclic ring system with one another, or an electron-transport unit R³, but with the proviso that at least one of the radicals R¹ is an electron-transport unit R³,
Ar¹ is selected on each occurrence, in each case independently of one another, from an aryl or heteroaryl group or an aromatic or heteroaromatic ring system,
R² is in each case, independently of one another, H, an aliphatic hydrocarbon radical having 1 to 20 C atoms or an aromatic hydrocarbon radical having 6 to 20 C atoms, where two or more radicals R² may also form a ring system with one another,
R³ is an electron-transport unit which is selected from the group consisting of benzimidazole, triazine, pyrimidines, pyrazines, pyridazines, phenanthrolines, ketones, phosphine oxides and derivatives thereof,
where the dashed lines represent the bonds to the adjacent structural units in the polymer.

2. Polymer according to Claim 1, **characterised in that**, besides the structural units of the formula (I), it also contains further structural units which are different from those of the formula (I).

3. Polymer according to Claim 1 or 2, **characterised in that** the proportion of the units of the formula (I) is 0.01 to 100 mol%, based on the total number of recurring units of the polymer.

4. Process for the preparation of a polymer according to one or more of Claims 1 to 3, **characterised in that** it is prepared by SUZUKI, YAMAMOTO, STILLE or HARTWIG-BUCHWALD polymerisation.

5. Mixture of one or more polymers according to one or more of Claims 1 to 3 with a further polymeric, oligomeric, dendritic and/or low-molecular-weight substance.

6. Solution or formulation comprising one or more polymers according to one or more of Claims 1 to 3 or a mixture according to Claim 5 in one or more solvents.

7. Use of a polymer according to one of Claims 1 to 3, a mixture according to Claim 5 or a solution according to Claim 6 in electronic devices, preferably in organic electroluminescent devices.

8. Organic electronic device having one or more active layers, **characterised in that** at least one of these active layers comprises one or more polymers according to one or more of Claims 1 to 3 or a mixture according to Claim 5.

9. Organic electronic device according to Claim 8, **characterised in that** it is an organic or polymeric organic electroluminescent device (OLED, PLED), organic integrated circuit (O-IC), organic field-effect transistor (OFET), organic thin-film transistor (OTFT), organic solar cell (O-SC), organic laser diode (O-laser), organic photovoltaic (OPV) element or device or organic photoreceptor (OPC), preferably a polymeric organic electroluminescent device (PLED).

## Revendications

1. Polymère qui contient au moins une unité structurelle des formules qui suivent (II), (IIIa) et/ou (IIIb) : 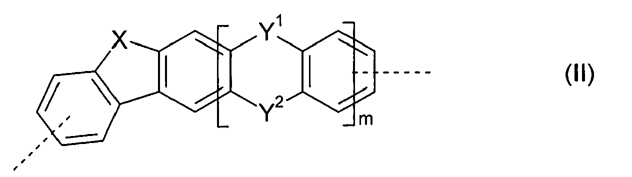 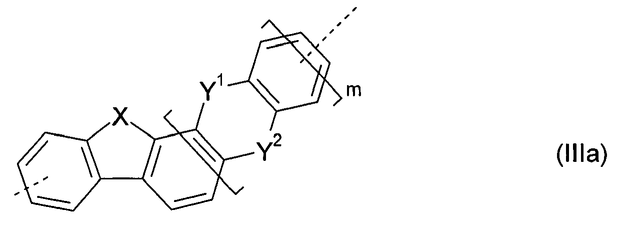 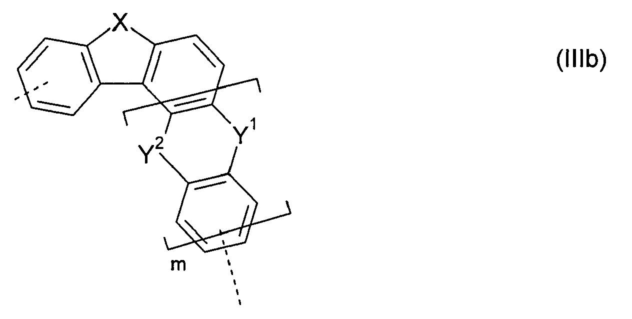 dans lesquelles les symboles et indices utilisés présentent la signification qui suit :
X est C(R¹)₂,
Y¹ et Y² sont chacun choisis, indépendamment l'un de l'autre, parmi C(R¹)₂, NR¹, C(R¹)₂-C(R¹)₂, CR¹=CR¹ et une liaison simple, mais étant entendu que soit Y¹, soit Y² est une liaison simple,
m est 0 ou 1,
R¹ est, dans chaque cas, choisi, indépendamment les uns des autres, parmi H, F, CI, Br, I, N(Ar¹)₂, C(=O)Ar¹, P(=O)Ar¹₂, S(=O)Ar¹, S(=O)₂Ar¹, CR²=CR²Ar¹, CN, NO₂, Si(R²)₃, B(OR²)₂, OSO₂R², un groupe alkyle, alcoxy ou thioalcoxy en chaîne droite comportant 1 à 40 atomes de C, un groupe alkyle, alcoxy ou thioalcoxy ramifié ou cyclique comportant 3 à 40 atomes de C, dont chacun peut être substitué par un radical ou plusieurs radicaux R², où un ou plusieurs groupes CH₂ non adjacents peut/peuvent être remplacés par R²C=CR², C=C, Si(R²)₂, Ge(R²)₂, Sn(R²)₂, C=O, C=S, C=Se, C=NR², P(=O)(R²), SO, SO₂, NR², O, S ou CONR² et où un ou plusieurs atomes de H peut/peuvent être remplacés par F, CI, Br, I, CN ou NO₂, un groupe aryle, aryloxy, hétéroaryle ou hétéroaryloxy comportant 5 à 40 atomes de C, lequel peut également être substitué par un radical ou plusieurs radicaux non aromatiques R¹, où, en outre, deux radicaux ou plus, de façon préférable deux radicaux adjacents R¹, peuvent former un système de cycle monocyclique ou polycyclique aliphatique ou aromatique l'un avec l'autre ou les uns avec les autre, ou une unité de transport d'électrons R³, mais étant entendu qu'au moins l'un des radicaux R¹ est une unité de transport d'électrons R³,
Ar¹ est choisi, pour chaque occurrence, dans chaque cas indépendamment des autres, parmi un groupe aryle ou hétéroaryle ou un système de cycle aromatique ou hétéroaromatique,
R² est, dans chaque cas, indépendamment des autres, H, un radical hydrocarbone aliphatique comportant 1 à 20 atomes de C ou un radical hydrocarbone aromatique comportant 6 à 20 atomes de C, où deux radicaux R² ou plus peuvent également former un système de cycle l'un avec l'autre ou les uns avec les autres,
R³ est une unité de transport d'électrons qui est choisie parmi le groupe constitué par benzimidazole, triazine, pyrimidines, pyrazines, pyridazines, phénanthrolines, cétones, oxydes de phosphine et leurs dérivés,
où les lignes en pointillés représentent les liaisons sur les unités structurelles adjacentes dans le polymère.

2. Polymère selon la revendication 1, **caractérisé en ce que**, en plus des unités structurelles de la formule (I), il contient également d'autres unités structurelles qui sont différentes de celles de la formule (I).

3. Polymère selon la revendication 1 ou 2, **caractérisé en ce que** la proportion des unités de la formule (I) est de 0,01 à 100 mol%, sur la base du nombre total d'unités récurrentes du polymère.

4. Procédé pour la préparation d'un polymère selon une ou plusieurs des revendications 1 à 3, **caractérisé en ce qu'**il est préparé au moyen d'une polymérisation de SUZUKI, de YAMAMOTO, de STILLE ou de HARTWIG-BUCHWALD.

5. Mélange d'un ou de plusieurs polymères selon une ou plusieurs des revendications 1 à 3 avec une autre substance polymérique, oligomérique, dendritique et/ou de poids moléculaire faible.

6. Solution ou formulation comprenant un ou plusieurs polymères selon une ou plusieurs des revendications 1 à 3 ou un mélange selon la revendication 5 dans un ou plusieurs solvants.

7. Utilisation d'un polymère selon l'une des revendications 1 à 3, d'un mélange selon la revendication 5 ou d'une solution selon la revendication 6 dans des dispositifs électroniques, de façon préférable dans des dispositifs électroluminescents organiques.

8. Dispositif électronique organique comportant une ou plusieurs couches actives, **caractérisé en ce qu'**au moins l'une de ces couches actives comprend un ou plusieurs polymères selon une ou plusieurs des revendications 1 à 3 ou un mélange selon la revendication 5.

9. Dispositif électronique organique selon la revendication 8, **caractérisé en ce qu'**il s'agit d'un dispositif électroluminescent organique ou organique polymérique (OLED, PLED), d'un circuit intégré organique (O-IC), d'un transistor à effet de champ organique (OFET), d'un transistor à film mince organique (OTFT), d'une cellule solaire organique (O-SC), d'une diode laser organique (O-laser), d'un élément ou dispositif photovoltaïque organique (OPV) ou d'un photorécepteur organique (OPC), de façon préférable un dispositif électroluminescent organique polymérique (PLED).
